Europäisches Patentamt

European Patent Office

Office européen des brevets

(11) Publication number: **0 356 839 B1**

# EUROPEAN PATENT SPECIFICATION

(45) Date of publication of patent specification: **31.03.93**  (51) Int. Cl.5: **C04B 35/49**, H01L 41/18

(21) Application number: **89115281.1**

(22) Date of filing: **18.08.89**

(54) **Piezoelectric ceramic material.**

(30) Priority: **31.08.88 JP 214813/88**

(43) Date of publication of application:
**07.03.90 Bulletin 90/10**

(45) Publication of the grant of the patent:
**31.03.93 Bulletin 93/13**

(84) Designated Contracting States:
**DE FR GB IT**

(56) References cited:
**EP-A- 0 087 004**
**GB-A- 2 004 268**
**US-A- 4 755 493**

**CHEMICAL ABSTRACTS, vol. 105, no. 22, December 1986, page 325, abstract no. 196189x, Columbus, Ohio, US; &JP-A-61 158 819 (DENKI KAGAKU KOGYO K.K.) 18-06-1986**

(73) Proprietor: **TAIYO YUDEN KABUSHIKI KAISHA No. 16-20, Ueno 6-chome Taito-ku Tokyo(JP)**

(72) Inventor: **Nagasawa, Seizi**
**Taiyo Yuden K.K. No. 16-20, Ueno 6-chome Taito-ku Tokyo(JP)**
Inventor: **Ban, Hiroshi**
**Taiyo Yuden K.K. No. 16-20, Ueno 6-chome Taito-ku Tokyo(JP)**
Inventor: **Narita, Naoto**
**Taiyo Yuden K.K. No. 16-20, Ueno 6-chome Taito-ku Tokyo(JP)**

(74) Representative: **Schmidt-Evers, Jürgen, Dipl.-Ing. et al Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10 W-8000 München 22 (DE)**

EP 0 356 839 B1

## Description

This invention relates to a piezoelectric ceramic material that can be used as various types of electromechanical transducer element for a buzzer, an actuator, a pressure sensor or the like, and more specifically to a piezoelectric ceramic material that can be produced by sintering at 850°C or lower temperature.

(Prior Art)

A three-component system solid solution such as $Pb(Mg_{1/3} Nb_{2/3})O_3$ . $PbTiO_3$ . $PbZrO_3$ or $Pb(Ni_{1/3} Nb_{2/3})O_3$ . $PbTiO_3$ . $PbZrO_3$, or the like has been known heretofore as a piezoelectric ceramic material of this kind comprising a composite perovskite oxide. Since said solid solution has superb electric and mechanical characteristics, it is widely used as a piezoelectric ceramic material which is generally called a "soft" material.

However, temperatures at which these conventional piezoelectric ceramic materials are sintered range generally between 1200°C and 1300°C. Even when a material which can be sintered at a comparatively lower temperature is used, the sintering temperature thus far had to be 1100°C or higher. Furthermore, since the melting point of PbO contained in such a piezoelectric ceramic material is 1000°C or lower and said PbO thus has a vapor pressure of several thousands of Pa. (tens of torr) at said sintering temperature, it is extremely difficult to prevent PbO from evaporating under this condition. In view of the fact that PbO vapors are highly harmful to a human body, therefore, it is by all means necessary to provide a preventive measure to avoid diffusion into the atmosphere of said vapors, thus requiring an environmental pollution prevention equipment to be provided therewith.

In addition, when PbO is evaporated, it causes an A-site defect of the piezoelectric ceramic. As a result, PbO contained in a piezoelectric ceramic material obtained by sintering is quantitatively uneven in a sinter and between sinters, thus causing partially uneven baking in the sinter and qualitative disparity between the sinters of different lots.

To solve the foregoing problems, there has been proposed, as disclosed in the Japanese Examined Patent Application Publication Tokkosho 62-57594, a manufacturing method of a piezoelectric ceramic material in which calcined powder consisting of an alkaline metallic salt and $PbF_2$ is added to calcined powder of lead titanate . zirconate as a sintering temperature depressant to carry out sintering at a temperature lower than the melting point of PbO, thereby preventing PbO from evaporating during sintering.

(Problems to be Solved by the Invention)

Since an alkaline metallic salt is used as one component of the sintering temperature depressant in the foregoing manufacturing method, the alkaline metallic salt which is water-soluble is eluted into an aqueous solvent during the manufacturing process of the material powder, thus causing quantity of the alkaline metallic salt contained in the material powder to be inconsistent from lot to lot. Consequently, there arises a problem of qualitative disparity among the piezoelectric ceramic materials produced by said method. Furthermore, the piezoelectric ceramic material obtained by said method gives a low electromechanical coupling factor or only 52% at most.

If an organic solvent such as alcohol or acetone is used in the mixing process to mix materials and in the grinding or pulverizing process after calcination, elution into the solvent of the alkaline metallic salt can be prevented. This, however, requires to make all the manufacturing facilities explosion-proof, so that it should incur much greater equipment cost and consequently higher production cost.

In addition, since any one of the piezoelectric ceramic materials obtained by the foregoing method contains an alkaline metallic salt, there is in general a danger that said alkaline metallic salt is gradually eluted out of the ceramic material when placed in water or in a high-humidity environment. This gives rise to a reliability problem in view of the existing industrial standard on electronic parts that electric characteristics of an electronic part should remain undeteriorated even when left under humidity of 90% RH or higher for 1000 hours.

It is, therefore, the object of the present invention to provide a piezoelectric ceramic material that is free from the foregoing problems.

(Means for Solving the Problems)

To attain the above object, the present invention provides a piezoelectric ceramic material mainly composed of a composite perovskite oxide whose composition is expressed by a general formula of:

$$Pb\ (\ Ni_{1/3}\ Nb_{2/3}\ )_a\ .\ (\ Zn_{1/3}\ Nb_{2/3})_b\ .\ (\ Fe_{2/3}\ .\ W_{1/3})_c\ .\ (\ Ti_x\ Zr_y\ )_d\ O_3\ ,$$

wherein

$a + b + c + d = 1$,
$0.20 < a + b < 0.50$,
$0.02 < c < 0.15$, and
$x + y = 1$,

(where a, b, c, d, x and y all represent a positive number), and an A site/B-site molar ratio thereof is 1.01 or higher.

The reason why the component ratio has been defined as indicated above in the general formula is because, with the ratio falling outside of the defined range, there can not be obtained a piezoelectric ceramic material having a practically sufficient electromechanical coupling factor when sintered at 850°C or lower. Especially when the "a + b" value is greater than 0.50, it is difficult for the ceramic material to have a perovskite crystal structure which manifests piezoelectricity formed therein so that said ceramic material will not show the piezoelectric property. This will cause Curie temperature of the piezoelectric ceramic to drop to 180°C or lower and the piezoelectric property thereof to become unstable with respect to environmental temperatures, thus making the product unsuitable for practical use. Further, when "c" value is greater than 0.15, an insulation resistance value of the sinter becomes lower and there should arise a problem that a dielectric breakdown of the element made of such a ceramic material is more likely to occur at the time of polarization.

The x and y values that determine the solid solution ratio of lead titanate ($PbTiO_3$) to lead zirconate ($PbZrO_3$), both of which are contained in the component $Pb(Ti_xZr_y)_dO_3$ can be appropriately selected so as to obtain a suitable electromechanical coupling factor.

As for the A-site/B-site molar ratio of the composite perovskite oxide, it is preferrable to set the ratio at 1.01 - 1.03 for the purpose of preventing the dielectric strength of the piezoelectric ceramic material from becoming lower.

(Embodiment)

Now, an embodiment example of the present invention together with a comparison example will be explained for one to understand the present invention better.

To provide an embodiment example of the present invention, each of the industrial-use metal oxide powders, NiO, ZnO, $Fe_2O_5$, $Nb_2O_5$, $WO_3$, and $ZrO_2$ was accurately weighed to conform to each component ratio indicated on Table given hereinafter. After mixing them by a wet ball mill for 10 hours, they were calcined at 1000°C in the atmosphere for two hours to obtain calcined powder thereof. The calcined powder was put in the ball mill, ground and mixed again thereby for another 10 hours and, thereafter, the remaining components PbO and $TiO_2$ were added thereto in accordance with their respective component ratios shown on the Table, and mixed with the others. The mixture was then calcined at 750°C in the atmosphere for was measured respectively of electric characteristics including relative dielectric constant ($\epsilon$) and dielectric loss ($\tan\delta$) before and after the polarization treatment, and radial electromechanical coupling factor (Kp%). The results obtained thereby are as shown on the Table.

T A B L E

| | COMPONENT RATIO | | | | | | COMPOUNDED AMOUNT OF LEAD OXIDE A-site/B-site Molar Ratio | ELECTRIC CHARACTERISTICS | | | | ELECTROMECHANICAL COUPLING FACTOR (Kp%) |
| | | | | | | | | BEFORE POLARIZATION | | AFTER POLARIZATION | | |
| | a | b | c | d | x | y | | RELATIVE DIELECTRIC CONSTANT ($\epsilon$) | DIELECTRIC LOSS (tan $\delta$) | RELATIVE DIELECTRIC CONSTANT ($\epsilon$) | DIELECTRIC LOSS (tan $\delta$) | |
|---|---|---|---|---|---|---|---|---|---|---|---|---|
| EXAMPLE 1 | 0.112 | 0.168 | 0.020 | 0.700 | 0.56 | 0.44 | 1.02 | 1,668 | 3.25 | 2,201 | 2.87 | 52 |
| EXAMPLE 2 | 0.304 | 0.076 | 0.020 | 0.600 | 0.60 | 0.40 | 1.02 | 2,697 | 2.77 | 3,577 | 2.61 | 52 |
| EXAMPLE 3 | 0.228 | 0.152 | 0.020 | 0.600 | 0.56 | 0.44 | 1.02 | 2,386 | 3.04 | 3,253 | 2.80 | 56 |
| EXAMPLE 4 | 0.228 | 0.152 | 0.020 | 0.600 | 0.60 | 0.40 | 1.02 | 2,534 | 2.31 | 3,199 | 2.25 | 54 |
| EXAMPLE 5 | 0.152 | 0.228 | 0.020 | 0.600 | 0.56 | 0.44 | 1.02 | 2,323 | 2.60 | 3,248 | 2.47 | 58 |
| EXAMPLE 6 | 0.152 | 0.228 | 0.020 | 0.600 | 0.60 | 0.40 | 1.02 | 2,166 | 2.01 | 2,624 | 1.51 | 54 |
| EXAMPLE 7 | 0.076 | 0.304 | 0.020 | 0.600 | 0.56 | 0.44 | 1.02 | 2,261 | 2.25 | 3,198 | 2.04 | 55 |
| EXAMPLE 8 | 0.176 | 0.044 | 0.080 | 0.700 | 0.52 | 0.48 | 1.02 | 1,926 | 2.41 | 2,612 | 1.93 | 54 |
| EXAMPLE 9 | 0.132 | 0.088 | 0.080 | 0.700 | 0.52 | 0.48 | 1.02 | 1,978 | 2.09 | 2,723 | 1.49 | 59 |
| EXAMPLE 10 | 0.088 | 0.132 | 0.080 | 0.700 | 0.52 | 0.48 | 1.02 | 1,920 | 1.66 | 2,652 | 1.19 | 59 |
| EXAMPLE 11 | 0.044 | 0.176 | 0.080 | 0.700 | 0.52 | 0.48 | 1.02 | 1,787 | 1.44 | 2,398 | 1.01 | 56 |
| EXAMPLE 12 | 0.189 | 0.081 | 0.080 | 0.650 | 0.48 | 0.52 | 1.02 | 2,300 | 2.11 | 3,115 | 1.58 | 55 |
| EXAMPLE 13 | 0.189 | 0.081 | 0.080 | 0.650 | 0.52 | 0.48 | 1.02 | 2,020 | 1.98 | 2,525 | 1.53 | 54 |
| EXAMPLE 14 | 0.162 | 0.108 | 0.080 | 0.650 | 0.48 | 0.52 | 1.02 | 2,171 | 2.07 | 2,912 | 1.50 | 56 |
| EXAMPLE 15 | 0.162 | 0.108 | 0.080 | 0.650 | 0.52 | 0.48 | 1.02 | 2,093 | 2.45 | 2,706 | 1.93 | 61 |
| EXAMPLE 16 | 0.162 | 0.108 | 0.080 | 0.650 | 0.56 | 0.44 | 1.02 | 2,258 | 1.86 | 2,880 | 1.28 | 59 |
| EXAMPLE 17 | 0.135 | 0.135 | 0.080 | 0.650 | 0.48 | 0.52 | 1.02 | 2,130 | 2.01 | 2,895 | 1.47 | 57 |
| EXAMPLE 18 | 0.135 | 0.135 | 0.080 | 0.650 | 0.52 | 0.48 | 1.02 | 2,040 | 2.28 | 2,815 | 1.90 | 66 |

(continued)

EP 0 356 839 B1

T A B L E

| | COMPONENT RATIO | | | | | | COMPOUNDED AMOUNT OF LEAD OXIDE A-site/B-site Molar Ratio | ELECTRIC CHARACTERISTICS | | | | ELECTROMECHANICAL COUPLING FACTOR (Kp%) |
| | | | | | | | | BEFORE POLARIZATION | | AFTER POLARIZATION | | |
| | a | b | c | d | x | y | | RELATIVE DIELECTRIC CONSTANT ($\varepsilon$) | DIELECTRIC LOSS (tan δ) | RELATIVE DIELECTRIC CONSTANT ($\varepsilon$) | DIELECTRIC LOSS (tan δ) | |
| EXAMPLE 19 | 0.135 | 0.135 | 0.080 | 0.650 | 0.56 | 0.44 | 1.02 | 2,146 | 1.78 | 2,651 | 1.29 | 56 |
| EXAMPLE 20 | 0.108 | 0.162 | 0.080 | 0.650 | 0.48 | 0.52 | 1.02 | 2,023 | 1.87 | 2,681 | 1.54 | 55 |
| EXAMPLE 21 | 0.108 | 0.162 | 0.080 | 0.650 | 0.52 | 0.48 | 1.02 | 2,070 | 2.30 | 3,370 | 2.15 | 67 |
| EXAMPLE 22 | 0.081 | 0.189 | 0.080 | 0.650 | 0.48 | 0.52 | 1.02 | 1,893 | 1.75 | 2,423 | 1.50 | 53 |
| EXAMPLE 23 | 0.081 | 0.189 | 0.080 | 0.650 | 0.52 | 0.48 | 1.02 | 1,952 | 2.40 | 2,850 | 2.10 | 61 |
| EXAMPLE 24 | 0.054 | 0.216 | 0.080 | 0.650 | 0.52 | 0.48 | 1.02 | 1,876 | 2.54 | 2,640 | 2.00 | 57 |
| EXAMPLE 25 | 0.256 | 0.064 | 0.080 | 0.600 | 0.56 | 0.44 | 1.02 | 2,874 | 2.54 | 3,907 | 2.04 | 56 |
| EXAMPLE 26 | 0.256 | 0.064 | 0.080 | 0.600 | 0.60 | 0.40 | 1.02 | 2,869 | 2.14 | 3,396 | 1.50 | 53 |
| EXAMPLE 27 | 0.224 | 0.096 | 0.080 | 0.600 | 0.56 | 0.44 | 1.02 | 2,844 | 2.25 | 4,099 | 1.58 | 65 |
| EXAMPLE 28 | 0.224 | 0.096 | 0.080 | 0.600 | 0.60 | 0.40 | 1.02 | 2,589 | 2.05 | 3,070 | 1.51 | 52 |
| EXAMPLE 29 | 0.192 | 0.128 | 0.080 | 0.600 | 0.56 | 0.44 | 1.02 | 2,813 | 2.23 | 4,038 | 1.65 | 62 |
| EXAMPLE 30 | 0.192 | 0.128 | 0.080 | 0.600 | 0.60 | 0.40 | 1.02 | 2,405 | 1.93 | 2,819 | 1.33 | 53 |
| EXAMPLE 31 | 0.160 | 0.160 | 0.080 | 0.600 | 0.56 | 0.44 | 1.02 | 2,621 | 2.23 | 3,416 | 1.58 | 58 |
| EXAMPLE 32 | 0.128 | 0.192 | 0.080 | 0.600 | 0.56 | 0.44 | 1.02 | 2,437 | 2.26 | 3,020 | 1.60 | 55 |
| EXAMPLE 33 | 0.096 | 0.224 | 0.080 | 0.600 | 0.56 | 0.44 | 1.02 | 2,415 | 2.01 | 2,725 | 1.52 | 52 |
| EXAMPLE 34 | 0.282 | 0.188 | 0.080 | 0.450 | 0.56 | 0.44 | 1.02 | 2,887 | 2.57 | 4,489 | 2.17 | 54 |

(continued)

EP 0 356 839 B1

T A B L E

| | | COMPONENT RATIO | | | | | COMPOUNDED AMOUNT OF LEAD OXIDE A-site/B-site Molar Ratio | ELECTRIC CHARACTERISTICS | | | | ELECTROMECHANICAL COUPLING FACTOR (Kp%) |
|---|---|---|---|---|---|---|---|---|---|---|---|---|
| | | | | | | | | BEFORE POLARIZATION | | AFTER POLARIZATION | | |
| | a | b | c | d | x | y | | RELATIVE DIELECTRIC CONSTANT ( $\epsilon$ ) | DIELECTRIC LOSS (tan $\delta$) | RELATIVE DIELECTRIC CONSTANT ( $\epsilon$ ) | DIELECTRIC LOSS (tan $\delta$) | |
| EXAMPLE 35 | 0.282 | 0.188 | 0.080 | 0.450 | 0.60 | 0.40 | 1.02 | 3,042 | 2.43 | 3,954 | 2.55 | 55 |
| EXAMPLE 36 | 0.188 | 0.282 | 0.080 | 0.450 | 0.56 | 0.44 | 1.02 | 2,714 | 2.34 | 3,364 | 1.86 | 59 |
| EXAMPLE 37 | 0.188 | 0.282 | 0.080 | 0.450 | 0.60 | 0.40 | 1.02 | 2,355 | 2.06 | 2,709 | 1.67 | 54 |
| EXAMPLE 38 | 0.030 | 0.120 | 0.150 | 0.700 | 0.48 | 0.52 | 1.02 | 1,765 | 3.07 | 1,870 | 1.82 | 56 |
| EXAMPLE 39 | 0.080 | 0.120 | 0.150 | 0.650 | 0.52 | 0.48 | 1.02 | 2,381 | 2.28 | 3,006 | 1.60 | 59 |
| EXAMPLE 40 | 0.040 | 0.160 | 0.150 | 0.650 | 0.52 | 0.48 | 1.02 | 2,156 | 2.10 | 2,471 | 1.63 | 52 |
| EXAMPLE 41 | 0.240 | 0.160 | 0.150 | 0.450 | 0.52 | 0.48 | 1.02 | 2,432 | 2.19 | 3,087 | 1.74 | 57 |
| EXAMPLE 42 | 0.160 | 0.240 | 0.150 | 0.450 | 0.52 | 0.48 | 1.02 | 2,298 | 2.20 | 2,871 | 1.86 | 53 |
| COMPARISON EXAMPLE 1 | 0.360 | 0.040 | --- | 0.600 | 0.60 | 0.40 | 1.02 | 2,310 | 3.10 | 3,619 | 2.74 | 48 |
| COMPARISON EXAMPLE 2 | 0.360 | 0.040 | --- | 0.600 | 0.64 | 0.36 | 1.02 | 2,337 | 2.52 | 3,134 | 2.01 | 30 |
| COMPARISON EXAMPLE 3 | 0.320 | 0.080 | --- | 0.600 | 0.60 | 0.40 | 1.02 | 2,227 | 3.02 | 3,067 | 2.44 | 38 |
| COMPARISON EXAMPLE 4 | 0.320 | 0.080 | --- | 0.600 | 0.64 | 0.36 | 1.02 | 2,308 | 2.28 | 3,174 | 1.69 | 30 |
| COMPARISON EXAMPLE 5 | 0.280 | 0.120 | --- | 0.600 | 0.60 | 0.40 | 1.02 | 2,180 | 2.68 | 3,424 | 2.28 | 47 |
| COMPARISON EXAMPLE 6 | 0.280 | 0.120 | --- | 0.600 | 0.64 | 0.36 | 1.02 | 2,237 | 2.20 | 2,939 | 1.62 | 30 |
| COMPARISON EXAMPLE 7 | 0.240 | 0.160 | --- | 0.600 | 0.60 | 0.40 | 1.02 | 2,103 | 2.47 | 3,187 | 2.01 | 43 |
| COMPARISON EXAMPLE 8 | 0.240 | 0.160 | --- | 0.600 | 0.64 | 0.36 | 1.02 | 1,800 | 1.99 | 2,258 | 1.50 | 30 |
| COMPARISON EXAMPLE 9 | 0.200 | 0.200 | --- | 0.600 | 0.60 | 0.40 | 1.02 | 2,141 | 2.22 | 3,095 | 1.71 | 41 |
| COMPARISON EXAMPLE 10 | 0.200 | 0.200 | --- | 0.600 | 0.64 | 0.36 | 1.02 | 1,698 | 1.92 | 2,065 | 1.49 | 30 |
| COMPARISON EXAMPLE 11 | 0.160 | 0.240 | --- | 0.600 | 0.60 | 0.40 | 1.02 | 1,936 | 2.08 | 2,642 | 1.60 | 39 |
| COMPARISON EXAMPLE 12 | 0.160 | 0.240 | --- | 0.600 | 0.64 | 0.36 | 1.02 | 1,578 | 1.80 | 1,888 | 1.39 | 30 |
| COMPARISON EXAMPLE 13 | 0.120 | 0.280 | --- | 0.600 | 0.60 | 0.40 | 1.02 | 1,826 | 1.97 | 2,285 | 1.72 | 35 |

(continued)

EP 0 356 839 B1

TABLE

| | COMPONENT RATIO | | | | | | COMPOUNDED AMOUNT OF LEAD OXIDE A-site/B-site Molar Ratio | ELECTRIC CHARACTERISTIC | | | | ELECTROMECHANICAL COUPLING FACTOR (Kp%) |
| | | | | | | | | BEFORE POLARIZATION | | AFTER POLARIZATION | | |
| | a | b | c | d | x | y | | RELATIVE DIELECTRIC CONSTANT ($\epsilon$) | DIELECTRIC LOSS (tan $\delta$) | RELATIVE DIELECTRIC CONSTANT ($\epsilon$) | DIELECTRIC LOSS (tan $\delta$) | |
|---|---|---|---|---|---|---|---|---|---|---|---|---|
| COMPARISON EXAMPLE 14 | 0.080 | 0.320 | --- | 0.600 | 0.60 | 0.40 | 1.02 | 1,776 | 1.80 | 2,115 | 1.60 | 30 |
| COMPARISON EXAMPLE 15 | 0.112 | 0.028 | 0.080 | 0.780 | 0.48 | 0.52 | 1.02 | 1,671 | 2.21 | 1,756 | 2.09 | 41 |
| COMPARISON EXAMPLE 16 | 0.084 | 0.056 | 0.080 | 0.780 | 0.48 | 0.52 | 1.02 | 1,703 | 2.01 | 1,821 | 1.95 | 45 |
| COMPARISON EXAMPLE 17 | 0.056 | 0.084 | 0.080 | 0.780 | 0.48 | 0.52 | 1.02 | 1,743 | 2.18 | 1,692 | 2.12 | 48 |
| COMPARISON EXAMPLE 18 | 0.028 | 0.112 | 0.080 | 0.780 | 0.48 | 0.52 | 1.02 | 1,803 | 2.57 | 1,761 | 2.35 | 42 |
| COMPARISON EXAMPLE 19 | 0.416 | 0.104 | 0.080 | 0.400 | 0.56 | 0.44 | 1.02 | 3,179 | 2.99 | 3,666 | 2.60 | 41 |
| COMPARISON EXAMPLE 20 | 0.416 | 0.104 | 0.080 | 0.400 | 0.60 | 0.40 | 1.02 | 3,461 | 3.01 | 3,721 | 2.51 | 42 |
| COMPARISON EXAMPLE 21 | 0.312 | 0.208 | 0.080 | 0.400 | 0.56 | 0.44 | 1.02 | 2,991 | 2.58 | 3,604 | 2.19 | 49 |
| COMPARISON EXAMPLE 22 | 0.312 | 0.208 | 0.080 | 0.400 | 0.60 | 0.40 | 1.02 | 3,293 | 2.45 | 3,703 | 2.39 | 49 |
| COMPARISON EXAMPLE 23 | 0.208 | 0.312 | 0.080 | 0.400 | 0.56 | 0.44 | 1.02 | 2,783 | 2.33 | 3,294 | 2.07 | 44 |
| COMPARISON EXAMPLE 24 | 0.208 | 0.312 | 0.080 | 0.400 | 0.60 | 0.40 | 1.02 | 2,987 | 2.15 | 3,471 | 1.73 | 45 |
| COMPARISON EXAMPLE 25 | 0.104 | 0.416 | 0.080 | 0.400 | 0.56 | 0.44 | 1.02 | 2,519 | 2.07 | 2,878 | 1.60 | 38 |
| COMPARISON EXAMPLE 26 | 0.104 | 0.416 | 0.080 | 0.400 | 0.60 | 0.40 | 1.02 | 2,625 | 1.81 | 3,112 | 1.54 | 40 |
| COMPARISON EXAMPLE 27 | 0.315 | 0.035 | 0.180 | 0.470 | 0.52 | 0.48 | 1.02 | 2,203 | 2.67 | 2,098 | 2.00 | 24 |
| COMPARISON EXAMPLE 28 | 0.280 | 0.070 | 0.180 | 0.470 | 0.52 | 0.48 | 1.02 | 2,291 | 1.98 | 2,121 | 1.50 | 24 |
| COMPARISON EXAMPLE 29 | 0.245 | 0.105 | 0.180 | 0.470 | 0.52 | 0.48 | 1.02 | 2,318 | 1.57 | 2,182 | 1.30 | 28 |
| COMPARISON EXAMPLE 30 | 0.210 | 0.140 | 0.180 | 0.470 | 0.52 | 0.48 | 1.02 | 2,571 | 1.46 | 2,336 | 1.08 | 30 |
| COMPARISON EXAMPLE 31 | 0.175 | 0.175 | 0.180 | 0.470 | 0.52 | 0.48 | 1.02 | 2,654 | 2.01 | 2,688 | 1.38 | 39 |
| COMPARISON EXAMPLE 32 | 0.140 | 0.210 | 0.180 | 0.470 | 0.52 | 0.48 | 1.02 | 2,531 | 2.28 | 3,156 | 1.60 | 49 |
| COMPARISON EXAMPLE 33 | 0.105 | 0.245 | 0.180 | 0.470 | 0.52 | 0.48 | 1.02 | 2,400 | 1.70 | 2,823 | 1.43 | 48 |
| COMPARISON EXAMPLE 34 | 0.070 | 0.280 | 0.180 | 0.470 | 0.52 | 0.48 | 1.02 | 2,297 | 2.10 | 2,621 | 1.63 | 45 |
| COMPARISON EXAMPLE 35 | 0.035 | 0.315 | 0.180 | 0.470 | 0.52 | 0.48 | 1.02 | 2,066 | 2.28 | 2,474 | 1.56 | 44 |

As is clear from the Table, the piezoelectric ceramic material used in the embodiment examples 1 through 42 gives before and after the polarization treatment the relative dielectric constant and dielectric loss which are such that they pose no practical problem, and the electromechanical coupling factor which is as high as 52% at the lowest. Compared with the above, the comparison examples 1 through 14 in which the ceramic material contained no c component or $Pb(Fe_{2/3} W_{1/3}) O_3$, the comparison examples 15 through

7

18 in which the ceramic material had a smaller component ratio for a component plus b component than that falling within the range thereof according to the present invention, the comparison examples 19 through 26 in which the ceramic material had a larger component ratio for a component plus b component than that falling within the range thereof according to the present invention, and the comparative examples 27 through 35 in which the ceramic material had a larger component ratio for c component than that falling within the range thereof according to the present invention, all showed a lower electromechanical coupling factor as compared with the embodiment examples although all of these comparison eaxamples gave a relative dielectric constant and a dielectric loss, before and after the polarization treatment, which are comparable to those in the embodiment examples.

(Effect of the Invention)

As described in the foregoing, according to the present invention, it is possible to produce even through a comparatively low temperature sintering a piezoelectric ceramic material that has a practically sufficient electromechanical coupling factor.

## Claims

1. A piezoelectric ceramic material mainly composed of a composite perovskite oxide whose composition is expressed by the general formula of:

$$Pb\ [(\ Ni_{1/3}\ Nb_{2/3}\ )_a\ .\ (\ Zn_{1/3}\ Nb_{2/3}\ )_b\ .\ (Fe_{2/3}\ .\ W_{1/3}\ )_c\ .\ (\ Ti_x\ Zr_y\ )_d]\ O_3$$

wherein

$a + b + c + d = 1$,
$0.20 < a + b < 0.50$,
$0.02 < c < 0.15$, and
$x + y = 1$,

(where a, b, c, d, x and y all represent a positive number), and an A-site/B-site molar ratio thereof is 1.01 or higher.

2. A piezoelectric ceramic material according to claim 1, wherein the A-site/B-site molar ratio of the composite perovskite oxide ranges from 1.01 to 1.03.

## Patentansprüche

1. Piezoelektrisches keramisches Material, hauptsächlich aus einem zusammengesetzten Perowskitoxid zusammengesetzt, dessen Zusammensetzung durch die allgemeine Formel:

$$Pb[(Ni_{1/3}Nb_{2/3})_a\ \bullet\ (Zn_{1/3}Nb_{2/3})_b\ \bullet\ (Fe_{2/3}W_{1/3})_c\ \bullet\ (Ti_xZr_y)_d]O_3$$

ausgedrückt wird, wobei

$a + b + c + d = 1$,
$0,20 < a + b < 0,50$,
$0,02 < c < 0,15$ und
$x + y = 1$,

(wobei a, b, c, d, x und y alle eine positive Zahl darstellen) und ein A-Stelle/B-Stelle Molverhältnis davon 1,01 oder höher ist.

2. Piezoelektrisches keramisches Material gemäß Anspruch 1, wobei das A-Stelle/B-Stelle Molverhältnis des zusammengesetzten Perowskitoxids zwischen 1,01 und 1,03 liegt.

**Revendications**

1. Matière céramique piézoélectrique principalement composée d'un composite d'oxyde de perovskite répondant à la formule générale :

   $Pb [(Ni_{1/3} Nb_{2/3})_a \bullet (Zn_{1/3} Nb_{2/3})_b \bullet (Fe_{2/3} \bullet W_{1/3})_c \bullet (Ti_x Zr_y)_d]O_3$,

   dans laquelle
   $a + b + c + d = 1$,
   $0,20 < a + b < 0,50$,
   $0,02 < c < 0,15$ et
   $x + y = 1$,

   (dans laquelle a, b, c, d, x et y représentent tous un nombre positif) et le rapport molaire site A/site B de celle-ci est de 1,01 ou davantage.

2. Matière céramique piézoélectrique selon la revendication 1, dans laquelle le rapport molaire site A/site B du composite d'oxyde de perovskite est compris entre 1,01 et 1,03.